# EUROPÄISCHE PATENTSCHRIFT

(11) **EP 0 366 135 B1**
(45) Veröffentlichungstag und Bekanntmachung des Hinweises auf die Patenterteilung: **01.09.1993**
(21) Anmeldenummer: 89119916.8
(22) Anmeldetag: 26.10.1989
(51) Int. Cl.: H01S 3/085, H01S 3/25, H01S 3/025

(54) **Halbleiterlaseranordnung für hohe Ausgangsleistung im lateralen Grundmodus**
Semiconductor laser arrangement for high output power in the lateral dominant mode
Dispositif laser à semi-conducteur à haute puissance de sortie dans le mode fondamental latéral

(30) Priorität: 28.10.1988 DE 3836802
(43) Veröffentlichungstag der Anmeldung: 02.05.1990
(73) Patentinhaber: SIEMENS AKTIENGESELLSCHAFT, 80333 München (DE)
(72) Erfinder: Hanke, Christian, Dr.-Ing., D-8000 München 83 (DE)

(56) Entgegenhaltungen:
- US-A- 4 284 963
- US-A- 4 698 129
- US-A- 4 744 089
- PATENT ABSTRACTS OF JAPAN, Band 9, Nr. 85 (E-308)[1808], 13. April 1985; & JP-A-59 217 384
- ELECTRONICS LETTERS, Band 24, Nr. 18, 1. September 1988, Seiten 1182-1183, Stevenage, Herts, GB; K. SHIGIHARA et al.: "High-power and fundamental-mode oscillating flared SBA lasers"
- PATENT ABSTRACTS OF JAPAN, Band 12, Nr. 362 (E-663), 28. September 1988; & JP-A-63 116 489

## Beschreibung

Die maximale Ausgangsleistung von AlGaAs-Laser wird im allgemeinen durch einen irreversiblen Spiegelschaden begrenzt, der bei einer bestimmten Lichtleistungsdichte einsetzt. Zur Steigerung der Ausgangsleistung kann die Emissionsfläche parallel zur aktiven Zone verbreitert werden, so daß bei gleicher maximaler Leistungsdichte die emittierte Lichtleistung ansteigt. Mögliche Wege dazu sind zum Beispiel Laserarraystrukturen mit mehreren optisch verkoppelten Einzelstreifenlasern oder sogenannte Breitstreifenlaser. Diese Laserstrukturen besitzen im allgemeinen die Eigenschaft, daß mehrere Lateralmoden der breiten Struktur ausbreitungsfähig sind und gleichzeitig schwingen. Dies führt zu breiten lateralen Fernfeldern mit mehreren Keulen. Eine beugungsbegrenzte Abbildung auf kleinste Fleckdurchmesser ist mit solchen lateral mehrmodigen Strukturen nicht möglich.

Es gibt eine Reihe von Arraystrukturen, die eine starke Modenselektion für den lateralen Grundmodus besitzen. Aufgrund von technisch bedingten Ungleichmäßigkeiten und wegen der starken Wechselwirkung von Lichtleistung und Wellenführung läßt sich aber ein stabiler Lateralmodus nur schwer über einen großen Leistungsbereich aufrechterhalten.

In der Patentschrift US-4 713 821 ist ein Halbleiterlaser beschrieben, der aus einem Laserbereich mit einem aktiven Laserstreifen und einem davon durch einen schmalen Koppelbereich getrennten Verstärkungsbereich, in dem die aktive Schicht trapezförmig aufgeweitet ist, besteht. Die in den Verstärkungsbereich ausgekoppelte Strahlung wird lateral aufgeweitet und tritt an der Stirnfläche aus dem Bauelement aus. Dieses Bauelement wird hergestellt, indem ein Substrat mit den darauf aufgewachsenen Halbleiterschichten auf einer ebenen Referenzoberfläche befestigt wird und dann längs einer Gitterebene, die die Grenze zwischen dem Laserbereich und dem Verstärkerbereich bildet, gespalten wird. Dieser Spalt bildet den Koppelbereich.

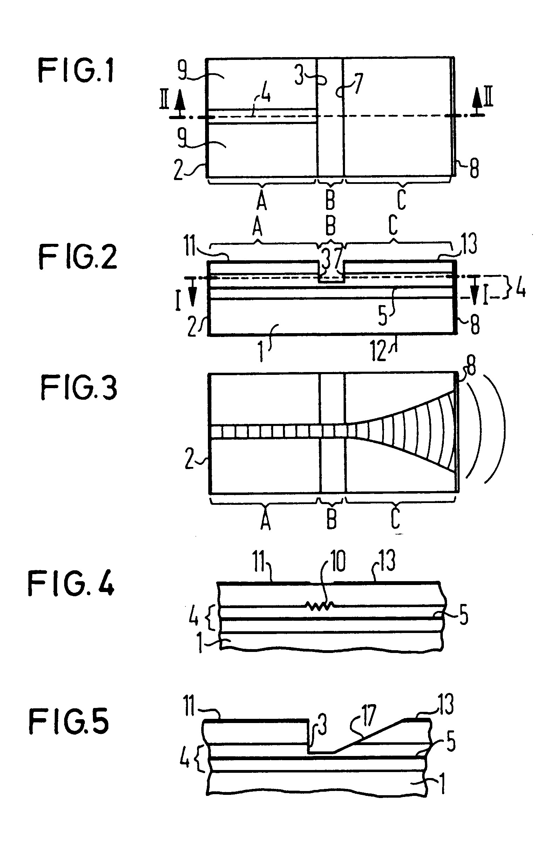

In der Patentschrift US-4 773 076 ist ein Halbleiterlaser beschrieben, bei dem ein durchgehend verlaufender Wellenleiter als aktive Schicht mit einer unterschiedlichen Breite in zwei verschiedenen Bereichen ausgebildet ist. In der Fig. 1b dieser Patentschrift ist die seitliche Bemessung der aktiven Schicht mit gestrichelten Linien dargestellt. Der zweite vorhandene Bereich dient hier nicht als Verstärkungsbereich, sondern als ein zweiter Laserresonator, der mit dem ersten Laserresonator verkoppelt ist. Wegen der durchgehend verlaufenden aktiven Schicht und entsprechend vorhandener Resonatorendflächen handelt es sich hierbei praktisch um einen in zwei Bereiche mit unterschiedlichen Resonatoreigenschaften aufgeteilten Laser.

Aufgabe der vorliegenden Erfindung ist es, eine einfach herstellbare Halbleiterlaserstruktur anzugeben, bei der der laterale Grundmodus stabil ist und die Emissionsfläche möglichst groß ist.

Diese Aufgabe wird mit einer erfindungsgemäßen Halbleiterlaseranordnung mit den Merkmalen des Ansprüches 1 gelöst.

Es folgt eine Beschreibung einer erfindungsgemäßen Halbleiterlaseranordnung anhand der Figuren 1 bis 5.
- Fig. 1: zeigt eine erfindungsgemäße Halbleiterlaseranordnung im Schnitt durch den Wellenleiter parallel zur überwachsenen Substratoberfläche.
- Fig. 2: zeigt eine erste Ausführungsform einer erfindungsgemäßen Halbleiterlaseranordnung im Längsschnitt.
- Fig. 3: zeigt die Ausbreitung der Wellenfronten der Laserstrahlung in einem erfindungsgemäßen Halbleiterlaser in dem Schnitt entsprechend Fig. 1
- Fig. 4: zeigt eine zweite Ausführungsform im Ausschnitt.
- Fig. 5: zeigt eine dritte Ausführungsform im Ausschnitt.
Die Erfindung besteht aus einer Halbleiterlaseranordnung, bei der auf einem gemeinsamen Substrat 1 integriert sind:
1. ein Laserbereich A, der in der in den Fig. 1 und 2 dargestellten Ausführungsform aus einem Einzelstreifenlaser mit lateraler und vertikaler Wellenführung besteht,
2. ein Koppelbereich B und
3. ein Verstärkungsbereich C, in dem die laterale Wellenführung aufgehoben ist.

Bei dem hier beschriebenen Ausführungsbeispiel wird der Einzellaser zum Beispiel als BH-Laser (buried heterostructure) oder als MCRW-Laser ausgebildet. Die laterale Wellenführung ist dadurch bewirkt, daß Seitenbereiche 9 aus dafür geeignetem Halbleitermaterial den Wellenleiter 4 lateral begrenzen. Der Wellenleiter 4 und die darin befindliche aktive Schicht 5 sind so bemessen, daß die erzeugte Laserstrahlung in beiden senkrecht zur Ausbreitungsrichtung liegenden Richtungen, d.h. lateral und vertikal, im Grundmodus schwingt.

In dem Verstärkungsteil C fehlt die laterale Wellenführung oder ist zumindest stark reduziert; eine Wellenführung erfolgt nur in vertikaler Richtung, d.h. senkrecht zum Verlauf der aktiven Schicht 5. Zwischen dem Laserbereich A und dem Verstärkungsbereich C liegt ein relativ schmal bemessener Koppelbereich B. Dieser Koppelbereich B ist erforderlich, um einerseits sicherzustellen, daß die Resonanzbedingung in dem Laserstreifen durch eine Reflexion an den Endflächen, d.h. der ersten Resonatorgrenzfläche 2 und der zweiten Resonatorgrenzfläche 3 in Figur 1, gegeben ist. Andererseits soll ein dem geforderten Koppelgrad entsprechender Anteil der Laserstrahlung in den Verstärkungsbereich C eingekoppelt werden können.

Die erfindungsgemäße Ausgestaltung des Koppelbereiches B sieht insbesondere drei Ausführungsformen vor:
In Fig. 2 ist ein Koppelbereich B im Längsschnitt dargestellt, bei dem die Grenzfläche zwischen dem Laserbereich A und dem Koppelbereich B (d.h. die zweite Resonatorgrenzfläche 3) und die Grenzfläche zwischen dem Koppelbereich B und dem Verstärkungsbereich C (d.h. die Eintrittsfläche 7 für den Eintritt der Strahlung in den Verstärkungsbereich C) jeweils aus einer senkrecht zur Ausbreitungsrichtung der Strahlung verlaufenden Spiegelfläche bestehen. Diese Spiegelflächen können durch Ätzen der Halbleiterschichtstruktur hergestellt werden. Der Laserbereich A und der Verstärkungsbereich C sind nicht vollständig voneinander getrennt; durch einen nur teilweisen Abtrag (Ätzen) der transversalen Wellenleiterstruktur entsteht ein Einschnitt, der eine longitudinale Störung des durchgehenden Wellenleiters 4 darstellt. Dadurch wird ein Teil der Lichtleistung in den Laserstreifen zurückreflektiert, nämlich durch die den Laserbereich A partiell begrenzende spiegelnde zweite Resonatorgrenzfläche 3. Der andere Anteil wird effektiv in den Verstärkungsbereich C eingekoppelt.

Eine gezielte Teilreflexion kann auch durch den Einbau einer longitudinalen Gitterstruktur in den wellenführenden Bereich erfolgen. Ein solches in den Wellenleiter 4 eingebautes (DBR)-Gitter 10 ist in Fig. 4 dargestellt. Ein derartiger DBR-Reflektor (distributed Bragg reflector) besitzt zudem eine wellenlängenselektive Rückkopplung, womit es möglich ist, zu erreichen, daß der schmale Laserstreifen auch longitudinal einmodig schwingt. Durch die Tiefe und sonstige Ausgestaltung des Gitters 10 läßt sich der gewünschte Reflexionsgrad einstellen.

Fig. 5 zeigt eine dritte Ausführungsform, bei der die Eintrittsfläche 17, die den Koppelbereich B von dem Verstärkungsbereich C zumindest teilweise abgrenzt, schräg zur Ausbreitungsrichtung der Strahlung verläuft. Vorteilhaft ist insbesondere die dargestellte Ausführungsform, bei der die Ebene der Eintrittsfläche 17 relativ zur Ebene der zweiten Resonatorgrenzfläche 3 um eine senkrecht zur Ausbreitungsrichtung, und zwar lateral im oben angegebenen Sinn, verlaufende Achse gedreht ist, und zwar so, daß die Weite des Koppelbereiches B in vom Substrat 1 wegweisender Richtung zunimmt. Durch diese schräge Ausführungsform der Eintrittsfläche 17 des Verstärkungsteiles C werden Reflexionen der optischen Welle beim Einkoppeln vermieden, die zu unerwünschten Fabry-Perot-Resonanzen im Koppelbereich B führen könnten. Die geneigte Eintrittsfläche 17 läßt sich zum Beispiel durch Ionenstrahlätzen erzeugen.

Ebenso ist es möglich, die in den beschriebenen Ausführungsformen vorhandenen Merkmale miteinander zu kombinieren. So kann zum Beispiel in der Ausführungsform nach Fig. 2 zusätzlich ein Gitter 10 wie in Fig. 4 eingebaut werden. Darüber hinaus kann die zweite Resonatorgrenzfläche 3 des Laserbereiches A und die Eintrittsfläche 7 in den Verstärkungsbereich C mit einer Beschichtung z. B. aus dielektrischem Material versehen sein. Es muß dabei nur sichergestellt sein, daß der Koppelbereich B eine genügende Reflexion von einigen Prozent für den schmalen Streifenlaser in den Laserbereich A besitzt, damit in dem Laser die Rückkoppelbedingung für das Anschwingen der Laseroszillation erfüllt ist. Zum anderen muß gewährleistet sein, daß die aus dem Laserbereich A austretende Lichtleistung effektiv in den Verstärkungsbereich C eingekoppelt werden kann.

Der Laserresonator in dem Laserbereich A ist auf der ersten Resonatorgrenzfläche 2 mit einer hochreflektierenden Schicht (z.B. Metall, dielektrischer Spiegel aus Al₂O₃-Si-Schichten) versehen. Das an der zweiten Resonatorgrenzfläche 3 in den Koppelbereich B austretende Licht wird über die Eintrittsfläche 7 in den Verstärkungsbereich C eingekoppelt. In diesem Verstärkungsbereich C ist die laterale Wellenführung zumindest verringert; es ist auch möglich, daß sich die Wellenleiterschicht in diesem Verstärkungsbereich C über die gesamte Breite des Aufbaues erstreckt.

Ein erster Metallkontakt 11 ist auf der Oberfläche des Laserbereiches A aufgebracht, ein zweiter Metallkontakt 12 befindet sich auf der Unterseite des Substrates 1, und ein dritter Kontakt 13 ist auf den Verstärkungsbereich C aufgebracht. Dieser dritte Kontakt 13 ist so ausgeführt, daß er eine Strominjektion in das Gebiet ermöglicht, in das sich das vom Laser kommende Licht unter Verbreiterung des Strahlenganges ausbreitet. Die Austrittsfläche 8 des Verstärkungsbereiches C ist durch eine dielektrische Beschichtung (z.B. Al₂O₃-Schichten) des Halbleiterkörpers entspiegelt, so daß keine Reflexion der Strahlung in den laseraktiven Bereich zurück erfolgen kann.

Die optische Welle, die vom schmalen Laserstreifen im Laserbereich A über den Koppelbereich B in den Verstärkungsbereich C eingekoppelt wird, schwingt im lateralen Grundmodus wegen der Abmessung des Wellenleiters 4 im Laserbereich A und breitet sich lateral im Quasifreistrahl (Öffnungswinkel 5 bis 10°) aus, da der Verstärkungsbereich C keine oder eine verminderte laterale Wellenführung besitzt. Bei der Aufweitung des Strahlenbündels bis an die Austrittsfläche 8 hin bleibt der laterale Grundmodus erhalten (Fig. 3). In vertikaler Richtung wird die Welle durch die vertikale Schichtstruktur des Wellenleiters 4 geführt. Diese Führung ist auch in dem Verstärkungsbereich C vorhanden. Durch geeignete Strominjektion in den Verstärkungsbereich C über den dritten Kontakt 13 wird in diesen Verstärkungsbereich C, der die gleiche vertikale Schichtstruktur wie der Laserbereich A besitzt, durch stimulierte Emission für eine optische Verstärkung gesorgt, die die durchlaufende optische Welle bis zur Austrittsfläche 8 hin verstärkt. Durch dieses Prinzip und die laterale Aufweitung der Welle lassen sich hohe Ausgangsleistungen bei Erhaltung des lateralen Grundmodus erreichen.

Die erfindungsgemäße Laseranordnung ist besonders einfach herstellbar, weil der Laserbereich (A) und der Verstärkungsbereich (C) auf einem gemeinsamen Substrat 1 aufgewachsen werden und der Koppelbereich (B) durch einen nachfolgenden Ätzschritt oder den Einbau eines DBR-Gitters leicht in einer für die vorgesehene Funktion optimierten Form ausgebildet werden kann. Daher läßt die erfindungsgemäße Laseranordnung zusätzlich zur verbesserten Funktionsweise eine höhere prozentuale Ausbeute an funktionstüchtigen Bauelementen bei der Produktion als bei herkömmlichen Ausführungsformen erwarten.

## Patentansprüche

1. Halbleiterlaseranordnung mit einem zur Strahlungserzeugung vorgesehenen Laserbereich (A), der mit einem ersten Kontakt (11) und mit einem zweiten Kontakt (12) zum Anlegen der Betriebsspannung versehen ist, mit einem Wellenleiter (4) für bezüglich der Ausbreitungsrichtung der Strahlung laterale und vertikale Wellenführung, mit einer verspiegelten ersten Resonatorgrenzfläche (2) und mit einer Austrittsfläche (8) für die Strahlung, wobei :
- sich zwischen der ersten Resonatorgrenzfläche (2) und der Austrittsfläche (8) ein an den Laserbereich (A) angrenzender Koppelbereich (B) und ein an diesen Koppelbereich (B) angrenzender Verstärkungsbereich (C) befinden,
- in diesem Verstärkungsbereich (C) die laterale Wellenführung soweit, wie für eine vorgegebene laterale Aufweitung des Strahlungsfeldes erforderlich ist, aufgehoben ist,
- der Koppelbereich (B) so ausgebildet ist, daß der Transmissionsgrad dieses Koppelbereiches (B) für Strahlung aus dem Laserbereich (A) innerhalb vorgegebener Grenzen liegt, so daß ein Teil der Lichtleistung in dem Laserbereich (A) Zurückgekoppelt wird und der verbleibende Teil in den Verstärkungsbereich (C) eingekoppelt wird, daß der Wellenleiter (4) vom Laserbereich (A) über den Koppelbereich (B) zum Verstärkungsbereich (C) durchgehend ausgebildet ist,
- der in dem Laserbereich (A) angeordnete Anteil des Wellenleiters (4) so bemessen ist, daß die Laserstrahlung senkrecht zu ihrer Ausbreitungsrichtung im Grundmodus schwingt, und
- ein dritter Kontakt (13) zur Strominjektion in den Verstärkungsbereich (C) vorgesehen ist.

2. Halbleiterlaseranordnung nach Anspruch 1,
**dadurch gekennzeichnet,**
daß der Koppelbereich (B) durch eine zweite Resonatorgrenzfläche (3) zum Laserbereich (A) hin und durch eine Eintrittsfläche (7) zum Verstärkungsbereich (C) hin teilweise begrenzt ist.

3. Halbleiterlaseranordnung nach Anspruch 2,
**dadurch gekennzeichnet,**
daß zum Einstellen des Transmissionsgrades die zweite Resonatorgrenzfläche (3) und die Eintrittsfläche (7) mit Beschichtungen (6) versehen sind.

4. Halbleiterlaseranordnung nach Anspruch 2 oder 3,
**dadurch gekennzeichnet,**
daß die Eintrittsfläche (17) relativ zur zweiten Resonatorgrenzfläche (3) schräg verlaufend angeordnet ist.

5. Halbleiterlaseranordnung nach einem der Ansprüche 1 bis 4,
**dadurch gekennzeichnet,**
daß in dem Koppelbereich (B) ein Gitter (10) als DBR (distributed Bragg reflector) ausgebildet ist.

## Claims

1. Semiconductor laser arrangement having a laser region (A), provided for generating laser emission, which is provided with a first contact (11) and with a second contact (12) for applying the operating voltage, having a wave guide (4) for wave guidance that is lateral and vertical with respect to the direction of propagation of the emission, having a mirrored first resonator boundary surface (2), and having an exit face (8) for the emission, it being the case that:
- a coupling region (B) adjoining the laser region (A) and an amplifier region (C) adjoining this coupling region (B) are located between the first resonator boundary surface (2) and the exit face (8),
- in this amplifier region (C) the lateral wave guidance is cancelled to the extent required for a prescribed lateral broadening of the emission field,
- the coupling region (B) is constructed in such a way that the transmittance of this coupling region (B) lies within prescribed limits for emission from the laser region (A), so that a portion of the optical power in the laser region (A) is fed back and the remaining portion is coupled into the intensification region (C), the wave guide (4) being continuously constructed from the laser region (A) via the coupling region (B) to the amplifier region (C),
- the part of the wave guide (4) arranged in the laser region (A) is dimensioned in such a way that in the fundamental mode the laser emission oscillates perpendicularly to its direction of propagation, and
- a third contact (13) is provided for current injection into the amplifier region (C).

2. Semiconductor laser arrangement according to Claim 1, characterised in that the coupling region (B) is partially limited towards the laser region (A) by a second resonator boundary surface (3) and towards the amplifier region (C) by an entry face (7).

3. Semiconductor laser arrangement according to Claim 2, characterised in that the second resonator boundary surface (3) and the entry face (7) are provided with coatings (6) for setting the transmittance.

4. Semiconductor laser arrangement according to Claim 2 or 3, characterised in that the entry face (17) is arranged extending obliquely relative to the second resonator boundary surface (3).

5. Semiconductor laser arrangement according to one of Claims 1 to 4, characterised in that a lattice (10) is constructed in the coupling region (B) as a DBR (distributed Bragg reflector).

## Revendications

1. Dispositif à semiconducteurs comportant une zone d'émission laser (A), qui est prévue pour la production d'un rayonnement et qui est pourvue d'un premier contact (11) et d'un second contact (12) pour l'application de la tension de service, un guide d'ondes (4) pour le guidage latéral et vertical des ondes par rapport avec la direction de propagation du rayonnement, une première surface limite (2) de résonateur rendue réfléchissante et une surface de sortie (8) pour le rayonnement, et dans lequel :
- entre la première surface limite (2) du résonateur et la surface de sortie (8) sont disposées une zone de couplage (B), qui jouxte la zone d'émission laser (A), et une zone d'amplification (C), qui jouxte cette zone de couplage (B),
- le guidage latéral des ondes est supprimé dans cette zone d'amplification (C), dans la mesure où cela est nécessaire pour une extension latérale prédéterminée du champ de rayonnement,
- la zone de couplage (B) est agencée de telle sorte que le degré de transmission de cette zone de couplage (B) pour le rayonnement sortant de la zone d'émission laser (A) est située à l'intérieur de limites prédéterminées, de sorte qu'une partie de la puissance lumineuse est envoyée par réaction dans la zone d'émission laser (A) et que la partie restante est injectée dans la zone d'amplification (C),
- le guide d'ondes (4) s'étend continûment de la zone d'émission laser (A) à la zone d'amplification (C) en passant par la zone de couplage (B),
- la partie, disposée dans la zone d'émission laser (A), du guide d'ondes (4) est dimensionnée de telle sorte que la puissance laser oscille perpendiculairement à sa direction de propagation dans le mode fondamental, et
- un troisième contact (13) est prévu pour l'injection du courant dans la zone d'amplification (C).

2. Dispositif laser à semiconducteurs suivant la revendication 1, caractérisé par le fait que la zone de couplage (B) est limitée partiellement par une seconde surface limite (3) du résonateur en direction de la zone d'émission laser (A) et par une surface d'entrée (7) en direction de la zone d'amplification (C).

3. Dispositif laser suivant la revendication 2, caractérisé par le fait que pour le réglage du degré de transmission, la seconde surface limite (3) du résonateur et la surface d'entrée (7) sont pourvus de revêtements (6).

4. Dispositif laser à semiconducteurs suivant la revendication 2 ou 3, caractérisé par le fait que la surface d'entrée (17) est disposée obliquement par rapport à la seconde surface limite (3) du résonateur.

5. Dispositif laser à semiconducteurs suivant l'une des revendications 1 à 4, caractérisé par le fait qu'un réseau (10) est formé sous la forme d'un réflecteur DBR (distributed Bragg reflector) dans la zone de couplage (B).
